(19) **Europäisches Patentamt European Patent Office Office européen des brevets**

(11) **EP 2 734 854 B1**

(12) **FASCICULE DE BREVET EUROPEEN**

(45) Date de publication et mention de la délivrance du brevet:
**11.03.2020 Bulletin 2020/11**

(21) Numéro de dépôt: **12744056.8**

(22) Date de dépôt: **06.07.2012**

(51) Int Cl.:
*G01R 33/34* (2006.01)    *G01R 33/3415* (2006.01)
*G01R 33/561* (2006.01)    *G01R 33/36* (2006.01)

(86) Numéro de dépôt international:
**PCT/FR2012/051602**

(87) Numéro de publication internationale:
**WO 2013/011223 (24.01.2013 Gazette 2013/04)**

(54) **PROCEDE DE REALISATION D'UN MODULE COMPACT DE PILOTAGE D'UNE ANTENNE HAUTE FREQUENCE POUR APPAREIL D'IMAGERIE PAR RESONANCE MAGNETIQUE NUCLEAIRE**

VERFAHREN ZUR HERSTELLUNG EINES KOMPAKTEN STEUERMODULS FÜR EINE HOCHFREQUENZANTENNE EIN NMR-GERÄT

METHOD OF PRODUCING A COMPACT CONTROL MODULE FOR A HIGH-FREQUENCY ANTENNA FOR A NUCLEAR MAGNETIC RESONANCE IMAGING DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.07.2011 FR 1156597**

(43) Date de publication de la demande:
**28.05.2014 Bulletin 2014/22**

(73) Titulaire: **Commissariat à l'Énergie Atomique et aux Énergies Alternatives 75015 Paris (FR)**

(72) Inventeurs:
• **FERRAND, Guillaume**
  **F-75014 Paris (FR)**
• **LUONG, Michel**
  **F-94190 Villeneuve Saint Georges (FR)**

(74) Mandataire: **Lebkiri, Alexandre Cabinet Camus Lebkiri 25, Rue de Maubeuge 75009 Paris (FR)**

(56) Documents cités:
**US-A- 4 746 866      US-A- 4 751 464
US-A- 5 557 247      US-A1- 2008 272 783
US-A1- 2010 052 679**

• **SETSOMPOP K ET AL: "Slice-selective RF pulses for in vivo B1<+> inhomogeneity mitigation at 7 Tesla using parallel RF excitation with a 16-element coil", MAGNETIC RESONANCE IN MEDICINE, ACADEMIC PRESS, DULUTH, MN, US, vol. 60, no. 6, 1 décembre 2008 (2008-12-01), pages 1422-1432, XP007915199, ISSN: 0740-3194, DOI: 10.1002/MRM.21739 [extrait le 2008-11-24] cité dans la demande**
• **ALAGAPPAN V ET AL: "Degenerate mode band-pass birdcage coil for accelerated parallel excitation", MAGNETIC RESONANCE IN MEDICINE, ACADEMIC PRESS, DULUTH, MN, US, vol. 57, 29 mai 2007 (2007-05-29), pages 1148-1158, XP002528601, ISSN: 0740-3194, DOI: 10.1002/MRM.21247 cité dans la demande**

**Description**

La présente invention concerne le pilotage d'une antenne haute fréquence à voies multiples en réception et/ou en transmission, utilisées dans les appareils de Résonnance Magnétique Nucléaire (RMN), ainsi que leurs applications : Imagerie par Résonance Magnétique (IRM) pour l'homme ou l'animal, Spectroscopie par Résonance Magnétique (SRM), ou encore imagerie du tenseur de diffusion.

Le domaine de l'invention est celui de la Résonance Magnétique Nucléaire (RMN) et plus particulièrement celui des antennes haute-fréquence du type réseau phasé utilisés dans les appareils d'Imagerie par Résonance Magnétique (IRM) à très haut champ magnétique, c'est-à-dire supérieur ou égal à 7 Tesla.

L'invention s'applique particulièrement au pilotage d'une antenne haute fréquence de type réseau phasé utilisée pour examiner une partie du corps humain comme par exemple la tête d'un patient.

D'une façon connue, les antennes des appareils d'IRM sont formées par des éléments rayonnants de forme variable, en cuivre ou de bande de cuivre, jouant soit le rôle de bobinages émetteurs, en résonance avec le circuit qui l'alimente, soit le rôle de récepteurs de signaux de relaxation, soit plus généralement ces deux fonctions alternativement. Elles entourent le patient ou seulement la partie du corps à analyser.

Placées dans le champ magnétique longitudinal permanent $B_0$, d'un dispositif de RMN, elles reçoivent une excitation électrique leur permettant de produire le champ magnétique radiofréquence (RF) $B_1^+$ orthogonal à $B_0$, à la fréquence de résonance de précession (également appelée fréquence de Larmor) des noyaux des atomes étudiés qui se trouvent dans le champ magnétique $B_0$, et/ou captent l'écho, également onde radiofréquence à la fréquence de Larmor, produit par les atomes qui ont été momentanément soumis au champ magnétique $B_1^+$.

On rappelle que sous l'effet du champ magnétique statique $B_0$, les moments magnétiques de spin des noyaux d'atomes (par exemple d'hydrogène) vont progressivement s'aligner dans une direction initialement parallèle au champ magnétique $B_0$ et donner lieu à une aimantation globale dans la direction du champ $B_0$, dite direction longitudinale z.

Lorsqu'on applique une excitation sous forme d'impulsion, c'est-à-dire un champ magnétique oscillant à la fréquence de Larmor, noté $B_1^+$, les moments magnétiques de spin vont alors résonner et s'écarter progressivement de cet axe longitudinal z en décrivant un mouvement, appelé mouvement de précession. Le champ magnétique $B_1^+$ permet donc de faire « basculer » les moments magnétiques de spin pour les placer dans un plan perpendiculaire à la direction du champ $B_0$, selon un angle de bascule FA par rapport à la direction z.

Lorsque l'excitation est interrompue, les moments magnétiques de spin qui se sont écartés de leur axe initial reviennent vers leur position d'équilibre, c'est-à-dire l'axe z, sans cesser de tourner. Ce retour à l'équilibre est appelé relaxation. Il est alors possible de mesurer ce mouvement de rotation des spins sous la forme d'un signal oscillant de radiofréquence qui a la même fréquence que le champ magnétique excitateur, c'est-à-dire la fréquence de résonance de Larmor. Ce signal est ensuite capté par l'antenne commutée sur la chaîne de réception comportant des amplificateurs à très faible bruit ou encore par une autre antenne.

L'un des problèmes rencontrés avec de telles antennes de tête réside dans le fait qu'elles fonctionnent en champ électromagnétique proche, contrairement aux autres antennes, c'est-à-dire que les éléments physiques rayonnant sont placés près de l'échantillon (i.e. la tête du patient).

D'une façon classique, les intensités de champ magnétique $B_0$ utilisées en imagerie médicale sont comprises entre 0,1 et 3 Tesla.

A ces faibles intensités de champ magnétique, la fréquence de fonctionnement correspondant à la fréquence de Larmor reste faible. A titre d'exemple, pour un champ magnétique $B_0$ de 1,5 Tesla, la fréquence de Larmor correspondante est de 64 MHz et pour un champ magnétique $B_0$ de 3 Tesla, la fréquence de Larmor correspondante est de 128 MHz.

Généralement, les antennes utilisées pour l'examen de la tête à faible champ (entre 0,1 et 3 Tesla) sont des antennes, dites antenne volumique, du type cage d'écureuil (en anglais bird cage) ou TEM (pour Traverse Electric and Magnetic en langue anglaise) telles que décrit dans les documents US 4746866, US4751464, US 5557247. Ces antennes du type cage d'écureuil sont optimisées afin de produire le plus de champ magnétique avec le moins de puissance.

Ces antennes, du type cage d'écureuil, comportent un ensemble d'éléments rayonnants couplés et sont alimentées par une seule voie, c'est-à-dire une seule amenée de puissance créant un champ magnétique tournant, l'amenée de puissance étant elle-même alimentée par un seul élément de pilotage.

Ce type d'antenne permet d'obtenir des résultats satisfaisant et notamment un champ magnétique $B_1^+$ relativement homogène sur toute la zone à étudier à des intensités de champ magnétique dites à bas et à moyen champ magnétique. En effet, avec des champs magnétiques appliqués faibles, c'est-à-dire jusqu'à 3 Tesla, la fréquence de Larmor correspondante reste faible et les artefacts, dits de B1 ou RF (radiofréquences), sont tolérables.

Cependant, dans la course vers l'amélioration de la résolution des images, l'intensité du champ magnétique $B_0$ de l'aimant statique a tendance à être augmenté. Ainsi, pour des intensités de champ magnétique $B_0$ importantes, c'est-à-dire supérieures ou égales à 7 Tesla, les antennes de type cage d'écureuil deviennent critiques. En effet, la fréquence oscillante du champ magnétique $B_1$ devant être accordée à la fréquence de Larmor qui est proportionnelle à l'intensité du champ magnétique statique longitudinal $B_0$ devient alors supérieure à 298 Mhz pour le proton et la longueur d'onde effective du champ magnétique $B_1$ est relativement courte, de l'ordre de quelques dizaines de centimètres, c'est-à-dire de l'ordre de la taille de l'échantillon à étudier, notamment la tête du patient.

De plus, dans cette gamme de fréquences, une grande partie de la puissance électromagnétique est perdue dans l'échantillon, et notamment à la périphérie de l'échantillon ce qui implique que les zones éloignées de la périphérie de l'échantillon reçoivent moins de puissance. Dans cette gamme de fréquence, les ondes électromagnétiques ont également une forme irrégulière créant des concentrations locales du champ magnétique au centre de l'échantillon.

Pour remédier à ce problème d'inhomogénéité du champ magnétique, désigné par artéfact B1 ou RF, il a été développé des antennes, de type réseau phasé, formées par la combinaison d'une pluralité d'antennes de surface, également appelées éléments rayonnants, chaque antenne de surface comportant une voie propre, ou canal, d'émission et de réception du signal. Chaque antenne de surface permet ainsi de produire une image de la région anatomique en regard de laquelle elle se trouve, les différentes images sont ensuite combinées par des algorithmes pour former l'image finale. Il a été démontré par ailleurs que l'excitation des protons est rendue plus homogène lorsque le nombre d'éléments rayonnants d'une antenne augmente.

Dans les configurations actuelles d'exploitation de ces antennes de type réseau phasé, il convient que chaque canal de l'antenne soit relié à un amplificateur de puissance et que chaque amplificateur de puissance soit piloté indépendamment avec une amplitude et un déphasage particulier par une interface homme/machine.

L'inconvénient de cette technologie est le coût élevé de réalisation qui est dû notamment à la multiplication des amplificateurs de puissance et surtout à celui des électroniques de pilotage (pilotage de l'amplitude et pilotage du déphasage) nécessaires pour le pilotage de chaque canal de l'antenne. Ainsi, pour chaque canal de l'antenne, une chaîne de pilotage propre est attribuée.

Afin de réduire ces coûts de réalisation d'une antenne réseau, il a été développé des procédés de pilotage consistant à construire, à partir de $M$ signaux $V_m$ issus des $M$ chaines de pilotage et ayant une amplitude et une phase adéquates, les $N$ signaux $V_a$ ($M<N$) destinés aux $N$ éléments rayonnants. La correspondance entre les M signaux générés par les $M$ chaines de pilotage, et les $N$ signaux destinés aux $N$ éléments rayonnants est obtenue par un calcul exprimé ci-après, et qu'il est pratique d'exprimer sous forme matricielle. Il existe ainsi une matrice $P$, dite matrice de pilotage, telle que la matrice des divers signaux $V_a$ se déduit de la matrice des signaux $V_m$ en la multipliant par la matrice de pilotage $P$, qui a généralement des coefficients complexes :

$$V_a = PV_m$$

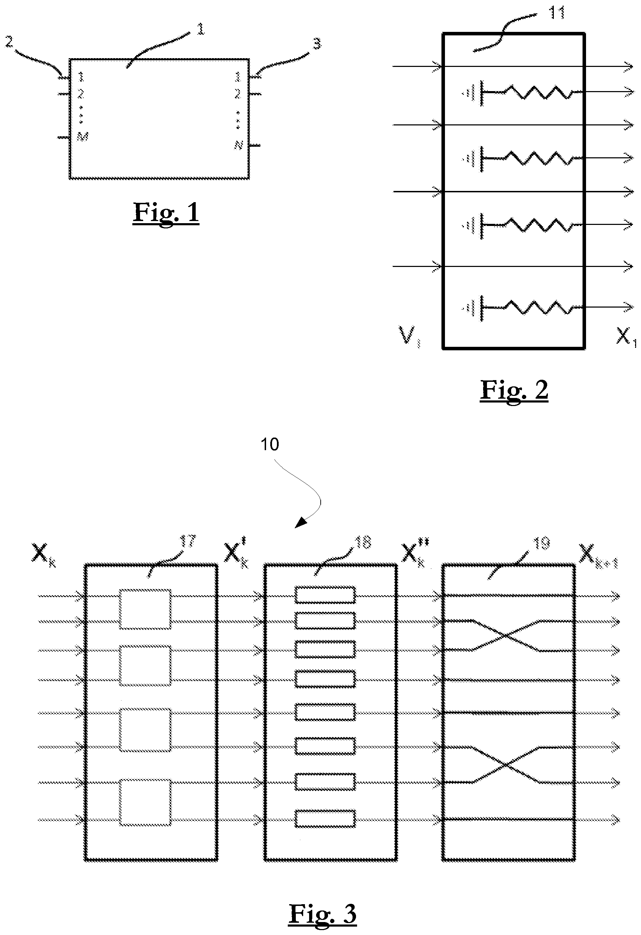

La figure 1 fournit une représentation schématique des entrées 2 et des sorties 3 associées à un module de pilotage 1 représentant une matrice de pilotage modale de $M$ modes (entrées) pour $N$ éléments rayonnants (sorties), avec $M<N$.

Jusqu'à présent ces procédés de réalisation de module de pilotage utilisent comme principe la décomposition de toutes les combinaisons d'excitation possibles sur une base orthogonale de $N$ modes ($N$ représentant le nombre d'éléments rayonnants répartis autour d'une coque cylindrique formant l'antenne). Cette décomposition fait avantageusement apparaitre que le nombre de modes réellement efficaces est inférieur au nombre $N$ d'éléments rayonnants.

Il est connu de réaliser une décomposition des combinaisons d'excitation en N modes orthogonaux selon deux méthodes qui permettent de convertir des signaux, de façon à ce qu'une chaîne de pilotage génèrant un signal d'entrée 2 associe au niveau de plusieurs sorties 3 un signal de même amplitude, ou d'amplitude différente, et dont la phase varie selon le mode de propagation à exciter.

Une première méthode consiste à utiliser une matrice de Butler, tel que mentionnée dans l'article « Slice-Selective RF pulses for in vivo B1 inhomogeneity mitigation at 7 Tesla using parallel RF excitation with a 16-Element coil », 2008, Kawin Setsompop et dans l'article « Degenerate mode bandpass birdcage coil for accelerated parallel excitation », 2007, Alagappan V. et al.

Une seconde méthode consiste à réaliser une décomposition en valeurs singulières (SVD pour Singular Value Décomposition en langue anglaise). En général, cette seconde méthode est préférable à la décomposition au moyen de la matrice de Butler car elle permet de prendre en compte l'interaction de l'antenne avec l'échantillon (i.e. la tête humaine) et permet d'ordonner par ordre d'efficacité les modes à exciter. Cette méthode de décomposition en valeurs singulières appliquée au pilotage d'une antenne réseau est particulièrement décrite dans la demande de brevet FR10/0072907.

Quelle que soit la méthode utilisée, un nombre *M* de modes d'excitation autour de *N/2* est suffisant pour obtenir un résultat satisfaisant en transmission parallèle. Il est d'ailleurs à noter que l'orthogonalité stricte des modes retenus n'est pas indispensable.

En pratique, la matrice de pilotage modal, appelée par la suite matrice P, résultant de la décomposition (par matrice de Butler ou par SVD) est construite physiquement par l'assemblage de plusieurs coupleurs et/ou de plusieurs déphaseurs de signaux.

Ainsi par exemple, pour une antenne comportant 16 éléments rayonnants, la matrice de pilotage *P* obtenue par l'utilisation de la matrice de Butler est réalisée au moyen de 4 étages successifs composés chacun de 8 coupleurs hybrides.

On rappelle que l'on entend par étage, la composition physique de trois éléments formés par des coupleurs hybrides, des lignes de déphasage et des permutations de lignes. Un étage permet donc de distribuer *N* signaux d'entrée sur *N* signaux de sorties différents, avec un déphasage et une permutation propre à chaque signal.

Compte tenu de la structure des coupleurs hydrides, comportant deux entrées et deux sorties, le maximum de canaux, ou d'éléments rayonnants N, excitables par une chaîne de pilotage pour *K* étage(s) est donnée par la relation par :

$$\max N = 2^K$$

De façon inverse, si l'antenne possède *N* éléments rayonnants, il est nécessaire que le nombre de canaux excitables par chaîne de pilotage soit supérieur au nombre d'éléments rayonnants *N*. Par conséquent, il est nécessaire que :

$$N \leq 2^K$$

En notant $E_{sup}(N)$ la partie entière « par excès » de *N,* c'est-à-dire l'entier le plus proche supérieur ou égal à *N,* on obtient que le nombre d'étages *K* doit être supérieur ou égale à :

$$E_{sup}(\ln(N)/\ln(2))$$

où,

- *N* est le nombre d'éléments rayonnants ;
- « ln » désigne le logarithme népérien.

A titre d'exemple, pour une antenne comportant 16 éléments rayonnants, la matrice de Butler nécessite un module de pilotage comportant 4 étages de 8 coupleurs et la matrice SVD, plus performante, nécessite un module de pilotage comportant 8 étages de 8 coupleurs.

Bien que physiquement réalisable, ces matrices de pilotage *P* (matrice de Butler ou matrice SVD) présentent toutefois une complexité de réalisation, un coût encore relativement important et une perte d'insertion non négligeable, c'est-à-dire une atténuation en puissance du signal entre l'entrée et la sortie (en dB) non négligeable.

Dans ce contexte, la présente invention vise à résoudre les problèmes mentionnés précédemment en proposant un procédé de réalisation d'un module de pilotage d'une antenne haute fréquence de type réseau phasé permettant de minimiser les coûts et la complexité de réalisation d'un tel module de pilotage tout en ayant une qualité et précision suffisante pour une application en Imagerie par Résonance Magnétique.

A cette fin, l'invention propose dans la revendication indépendante 1 un procédé de réalisation d'un module de pilotage compact d'une antenne haute fréquence pour appareil d'imagerie par résonance magnétique comportant une pluralité M d'éléments de pilotage et une pluralité *N* d'éléments rayonnants, ladite pluralité *N* d'éléments rayonnants étant supérieure à ladite pluralité *M* d'éléments de pilotage, ledit module de pilotage étant représenté par une matrice de pilotage $\tilde{P}$, $\tilde{P}$ étant une matrice approchée d'une matrice de pilotage P permettant de piloter ladite pluralité *N* d'éléments rayonnants à partir de ladite pluralité *M* d'éléments de pilotage.

L'invention consiste à proposer une décomposition avantageuse d'une matrice approchée $\tilde{P}$ d'une matrice de pilotage *P,* de type matrice de Butler ou matrice SVD, sous la forme d'un produit de deux matrices distinctes, une première matrice *L* et une deuxième matrice H , et avec une mise en œuvre de la matrice *L* sous forme numérique par des moyens logiciels, permettant ainsi de réduire la complexité de réalisation physique de la matrice de pilotage *P* par l'implémentation de la matrice H simplifié.

Les degrés de liberté supplémentaires et/ou les diverses possibilités de combinaison des signaux offertes par l'implémentation numérique de la matrice *L* permet de définir une matrice H simple et en particulier avec un nombre réduit d'étages, avantageusement avec un nombre d'étages inférieur au nombre d'étages nécessaire à l'implémentation de la matrice de pilotage P sans la décomposition avantageuse selon l'invention.

Le nombre d'étages *K* nécessaires à l'implémentation de la matrice H est typiquement inférieur à la relation : $E_{sup}(\ln(N)/\ln(2))$.

Ainsi, pour un exemple d'une antenne comportant 16 éléments rayonnants et 8 entrées ou modes pertinents à synthétiser, l'invention permet de ramener le nombre d'étages de 4 à 2 pour une configuration dite matrice de Butler et de 8 à 3 pour une configuration dite matrice SVD.

Avantageusement dans ces exemples de réalisation, un seul type de coupleur hybride est utilisé. Ce coupleur hybride est caractérisé par une répartition à 6 décibels (dB) de la puissance d'une entrée vers les deux sorties avec un déphasage de 90°.

Le procédé selon l'invention permet ainsi de réaliser un gain important par rapport à l'état de la technique en termes de robustesse, de coût, et de perte d'insertion pour la matrice de pilotage.

Le procédé selon l'invention peut également présenter une ou plusieurs des caractéristiques ci-dessous, considérées individuellement ou selon toutes les combinaisons techniquement possibles :

- ladite matrice H implémentée comporte un nombre d'étages *K* inférieur à :

$$E_{sup}(\ln(N)/\ln(2)) \,,$$

avec :

- $E_{sup}$ correspond à la partie entière supérieure
- *N* correspondant aux nombre d'éléments rayonnants de l'antenne ;
- « ln » correspondant au logarithme népérien.

- le procédé comporte une étape de décomposition de la matrice H en une pluralité *K+1* de matrice S selon la relation :

$$H = S_K, S_{K-1}, ..., S_1 S_0 \,,$$

avec :

$S_0$ matrice de dimension NxM
$S_k$ matrice de dimension NxN, avec k = {l,..., K}

- chacune desdites matrices $S_k$ avec k = {1,..., K} est formée par le produit matriciel d'une matrice de couplage $C_k$, d'une matrice de déphasage $\Phi_k$ et d'une matrice de permutation $\Pi_k$, de sorte qu'un signal $X_{k+1}$ en sortie de l'étage k du module de pilotage est fonction de la relation :

$$X_{k+1} = S_k X_k = \Pi_k \Phi_k C_k X_k \,,$$

avec $X_k$ représentant le signal d'entrée arrivant au niveau dudit étage *k* ;
- ladite matrice de couplage $C_k$ est différente de la matrice identité et implémentée par lesdits moyens de couplage, ladite matrice de déphasage $\Phi_k$ est implémentée par lesdits moyens de déphasage, et ladite matrice de permutations $\Pi_k$ est implémentée par des moyens de permutations ;
- lesdits moyens de couplage sont des coupleurs hybrides universaux ;
- lesdits moyens de couplage sont des coupleurs hybrides universaux à 6dB ;

L'invention a également pour objet un module de pilotage obtenu par le procédé de réalisation selon l'invention caractérisé en ce qu'il comporte un agencement de moyens de couplage, de moyens de déphasage et de moyens de permutations et de moyens logiciels de sorte qu'un signal $V_a$ de sortie dudit module de pilotage, est fonction de la relation :

$$V_a = HLV_m$$

avec :

- $V_m$ représentant les M signaux d'entrée dudit module de pilotage ;
- H matrice de dimension *NxM* apte à être implémentée par lesdits moyens de couplage, lesdits moyens de déphasage, lesdits moyens de permutations ;
- *L* matrice de dimension *MxM* apte à être mise en œuvre par lesdits moyens logiciels.

D'autres caractéristiques et avantages de l'invention ressortiront plus clairement de la description qui en est donnée ci-dessous, à titre indicatif et nullement limitatif, en référence aux figures annexées, parmi lesquelles :

- la figure 1 illustre une représentation schématique des entrées et des sorties d'un module de pilotage représentant une matrice de pilotage modale P permettant le pilotage d'une antenne haute fréquence, de type réseau phasé,
- la figure 2 illustre un exemple de réalisation d'une interface de distribution du module de pilotage illustré à la figure 1 :
- la figure 3 illustre un exemple de réalisation d'un étage complet du module de pilotage illustré à la figure 1 ;
- la figure 4 est un tableau illustrant les corrélations entre le paramètre d'angle $\theta$ et le couplage en dB ;
- la figure 5 illustre un exemple d'implémentation à deux étages de la matrice réduite H pour le pilotage d'une antenne haute fréquence, de type réseau phasé,
- la figure 6 représente les matrices des amplitudes et des phases de la matrice de Bulter pour le pilotage d'une antenne comportant 16 éléments rayonnants à partir de 8 éléments de pilotage ;
- la figure 7a représente des cartes de champs pour les modes impairs 1, 3, 5, et 7 obtenus au moyen d'une matrice de Butler ;
- la figure 7b représente des cartes de champs pour les modes impairs 1, 3, 5, et 7 obtenus au moyen du module de pilotage mise en œuvre par le procédé selon l'invention.

Dans toutes les figures, les éléments communs portent les mêmes numéros de référence.
La figure 1 a déjà été décrite précédemment en référence à la présentation de l'état de la technique.
Le procédé selon l'invention permet de réaliser un module de pilotage apte à piloter une antenne réseau phasé avec moins d'éléments de pilotage que d'éléments rayonnants de l'antenne (i.e. *N>M*).
On désigne par le terme « élément de pilotage » un sous-ensemble électronique comprenant généralement un modulateur d'amplitude et un modulateur de phase rapides qui sont contrôlés par le système informatique de l'appareil d'IRM et accessibles à l'opérateur à travers une interface homme-machine.
Considérons une matrice de pilotage P, généralement de valeurs complexes, de dimension *NxM,* permettant de transformer une variable d'entrée, notée $V_m$, représentant la tension vue aux ports des entrées de la matrice de pilotage *P* et associée à chacun des *M* modes, en une variable de sortie, notée $V_a$, représentant la tension vue aux ports des sorties, associée à chacun des *N* éléments rayonnants de l'antenne réseau.
Ainsi la matrice de pilotage P transforme $V_m$ en $V_a$ par le produit matriciel :

$$V_a = P.V_m$$

Le procédé selon l'invention permet d'implémenter une matrice de pilotage $\tilde{P}$ approchée qui soit facilement réalisable tout en minimisant l'erreur $\varepsilon$ définie par la relation :

$$\varepsilon = \left\|(\tilde{P} - P)W\right\|$$

où :

- || || désigne la norme euclidienne ;
- W désigne une matrice diagonale de dimension *MxM* dont les coefficients définissent le poids de chaque mode dans le calcul de l'erreur.

Plus les éléments W(i,i) de la matrice W sont grands, plus l'erreur acceptée pour le mode *i* considéré est petite. L'utilisation de la matrice W permet ainsi de minimiser l'erreur pour certains modes (i.e. les modes les plus importants) tout en donnant plus de liberté à d'autres modes.
L'implémentation de la matrice de pilotage approchée $\tilde{P}$ est décomposée en deux parties ou deux blocs :

- un premier bloc physique appelé par la suite répartiteur compact et qui est associé à une matrice réduite, appelée matrice H ;

- un deuxième bloc, dit bloc virtuel associé à une matrice virtuelle, appelée matrice L et qui est mise en œuvre par des moyens logiciels.

La matrice réduite H est de dimension $NxM$ et la matrice virtuelle L est de dimension $MxM$.

On associe à la matrice virtuelle $L$ une variable de sortie, notée $V_1$ (matrice colonne) définie par la relation :

$$V_l = L.V_{m'}$$

En d'autres termes, si l'utilisateur souhaite exciter un mode m, il suffira que les moyens logiciels calculent les signaux associés à la variable $V_1$ et les appliquent aux entrées du répartiteur compact caractérisé par la matrice réduite H .

Si la fabrication du répartiteur compact doit répondre à des contraintes physiques de faisabilité, le dispositif virtuel représentant la matrice virtuelle est quant à lui libre de toutes contraintes. Ainsi, le procédé selon l'invention permet d'optimiser une matrice de pilotage $P$ par le produit de deux matrices dont une matrice est une matrice réduite H apte à être réaliser simplement et facilement par le choix de coupleurs hybrides et préférentiellement par des coupleurs hybrides universaux de manière à réduire les coûts de réalisation d'un tel module de pilotage.

L'implémentation, ou fabrication, de la matrice H se fait au moyen d'une interface de distribution suivi d'un certain nombre de sous-ensembles de structure similaire appelés étages. A chacun de ces étages, d'indice $k$ ($k \neq 0$), est associé une matrice $S_k$ . La matrice $S_k$ permet de transformer une variable d'entrée $X_k$ en une variable de sortie $X_{k+1}$.

L'interface de distribution est définie par une matrice $S_0$ de dimension $NxM$ car elle permet de connecter les $M$ entrées aux $N$ sorties.

Les autres matrices $S_k$ sont des matrices carrées possédant $N$ entrées et $N$ sorties.

La première variable $X_0$ correspond à l'entrée du répartiteur compact, c'est-à-dire la variable $V_1$, et la dernière variable correspond aux signaux de sortie aptes à piloter l'antenne, c'est-à-dire la variable $V_a$.

Ainsi, si le nombre d'étage est égale à K, alors l'écriture matricielle donne :

$$V_a = S_K S_{K-1}...S_1 S_0 V_l$$

La matrice $S_0$ assure une connexion entre les $M$ entrées et $N$ les sorties sans modifier les signaux. Physiquement, cette première interface de distribution 11 dont un exemple de représentation est donné à la figure 2, peut comporter des connexions directes et des charges adaptées (50 $\Omega$, égale à l'impédance caractéristique des lignes de transmission). Ainsi, les éléments de la matrice $S_0$ s'écrivent simplement de la manière suivante : $S_0(i, j)$ = 1 si la sortie $i$ est connectée directement à l'entrée $j$, sinon l'élément vaut zéro.

Ainsi, par exemple, pour 8 entrées vers 16 sorties, $S_0$ peut prendre la forme :

$$S_0 = \begin{pmatrix} 1 & 0 & 0 & 0 & 0 & 0 & 0 & 0 \\ 0 & 0 & 0 & 0 & 0 & 0 & 0 & 0 \\ 0 & 1 & 0 & 0 & 0 & 0 & 0 & 0 \\ 0 & 0 & 0 & 0 & 0 & 0 & 0 & 0 \\ 0 & 0 & 1 & 0 & 0 & 0 & 0 & 0 \\ 0 & 0 & 0 & 0 & 0 & 0 & 0 & 0 \\ 0 & 0 & 0 & 1 & 0 & 0 & 0 & 0 \\ 0 & 0 & 0 & 0 & 0 & 0 & 0 & 0 \\ 0 & 0 & 0 & 0 & 1 & 0 & 0 & 0 \\ 0 & 0 & 0 & 0 & 0 & 0 & 0 & 0 \\ 0 & 0 & 0 & 0 & 0 & 1 & 0 & 0 \\ 0 & 0 & 0 & 0 & 0 & 0 & 0 & 0 \\ 0 & 0 & 0 & 0 & 0 & 0 & 1 & 0 \\ 0 & 0 & 0 & 0 & 0 & 0 & 0 & 0 \\ 0 & 0 & 0 & 0 & 0 & 0 & 0 & 1 \\ 0 & 0 & 0 & 0 & 0 & 0 & 0 & 0 \end{pmatrix}$$

On notera que chaque ligne de la matrice $S_0$ ne peut comporter qu'un seul élément égal à 1 car chaque entrée ne peut être connectée qu'à une seule sortie.

Les autres sous-ensembles, appelés étages, sont représentés par les matrices $S_k$ de dimension *NxN* pour k $\in \{1,...,E\}$.

A titre d'exemple, pour 3 étages (i.e. *K=3*), la matrice H peut s'écrire sous forme matricielle par la relation suivante : $H = S_3 S_2 S_1 S_0$.

Les matrices $S_k$ représentant les étages se décomposent eux-mêmes en trois parties : une matrice de couplage $C_k$, une matrice de déphasage $\Phi_k$ et une matrice de permutation $\Pi_k$.

La figure 3 donne la représentation physique d'un étage complet k représentant une matrice $S_k$ du répartiteur compact décrit précédemment. Les sorties de la matrice de couplage $C_k$ et de la matrice de déphasage $\Phi_k$ sont notées respectivement $X_k^{'}$ et $X_k^{"}$.

Les matrices de couplage $C_k$ sont matérialisées essentiellement par une juxtaposition de coupleurs hybrides 17, par exemple de type « branch-line » ([10] « Microwave Engineering », Wiley, N.Y. 1998 ; Pozar, D.).

Avantageusement, nous définissons par coupleurs hybride un coupleur universel caractérisé par un unique paramètre $\theta$. Chaque hybride universel 17 comporte deux entrées (e$_1$,e$_2$) et deux sorties ($\sigma_1$,$\sigma_2$) reliées par la transformation matricielle suivante :

$$\begin{pmatrix} \sigma_1 \\ \sigma_2 \end{pmatrix} = \begin{pmatrix} -j\cos\theta & -\sin\theta \\ -\sin\theta & -j\cos\theta \end{pmatrix} \begin{pmatrix} e_1 \\ e_2 \end{pmatrix},$$

où $\theta$ est un paramètre libre dans la conception d'un coupleur hybride et qui détermine le couplage, souvent exprimé en dB entre la seconde sortie ($\sigma_2$) et la première entrée (e$_1$). En d'autres termes, le paramètre $\theta$ définit la manière dont la puissance est répartie sur les deux sorties.

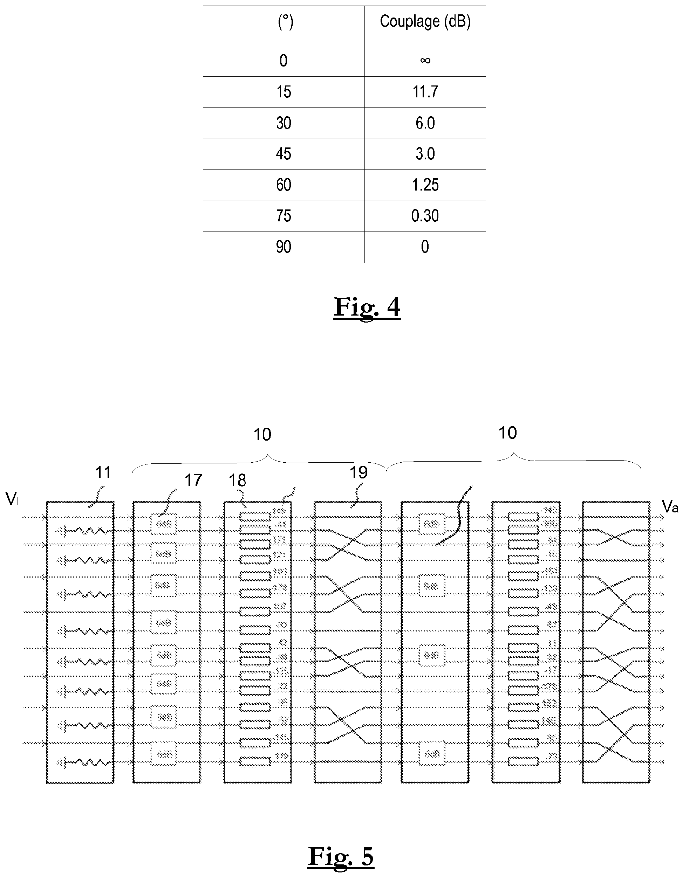

Le tableau illustré à la figure 4 donne différentes valeurs de l'angle $\theta$ pour différents couplage en dB.

Pour la construction d'un étage d'une antenne comportant N éléments rayonnants, avec *N* étant un nombre pair, on utilisera alors *N/2* coupleurs hybrides 17. Les entrées $X_k$ et les sorties $X_k^{'}$ de matrice $C_k$ sont alors reliées par les relations suivantes :

$$X_k^{'}(2i-1) = -j\cos\theta_{k,i} X_k(2i-1) - \sin\theta_{k,i} X_k(2i),$$

$$X_k^{'}(2i) = -\sin\theta_{k,i}\, X_k(2i-1) - j\cos\theta_{k,i}\, X_k(2i),$$

$$\text{pour}\quad i \in \left\{1,\dots,\frac{N}{2}\right\}.$$

En revanche, si le nombre $N$ d'éléments rayonnants de l'antenne est impair, on utilisera $(N-1)/2$ coupleurs hybrides universaux qui seront connectés comme précédemment mais pour $i \in \left\{1,\dots,\dfrac{N}{2}\right\}.$ Ainsi, le dernier élément de l'entrée est directement connecté à la sortie, c'est-à-dire que

$$X_k^{'}(N) = X_k(N).$$

Avec les notations précédentes, si le nombre $N$ d'éléments rayonnants est pair, les matrices de couplages $C_k$ prennent la forme d'une matrice bande (les éléments non nuls se regroupe autour de la diagonale) :

$$C_k = \begin{pmatrix} -j\cos\theta_{k,1} & -\sin\theta_{k,1} & 0 & 0 & \dots & 0 & 0 \\ -\sin\theta_{k,1} & -j\cos\theta_{k,1} & 0 & 0 & \dots & 0 & 0 \\ 0 & 0 & -j\cos\theta_{k,2} & -\sin\theta_{k,2} & \dots & 0 & 0 \\ 0 & 0 & -\sin\theta_{k,2} & -j\cos\theta_{k,2} & \dots & 0 & 0 \\ \vdots & \vdots & \vdots & \vdots & \ddots & \vdots & \vdots \\ 0 & 0 & 0 & 0 & \dots & -j\cos\theta_{k,N/2} & -\sin\theta_{k,N/2} \\ 0 & 0 & 0 & 0 & \dots & -\sin\theta_{k,N/2} & -j\cos\theta_{k,N/2} \end{pmatrix}$$

Si le nombre N d'éléments rayonnants est impair, alors les matrices $C_k$ seront de la forme :

$$C_k = \begin{pmatrix} -j\cos\theta_{k,1} & -\sin\theta_{k,1} & 0 & 0 & \dots & 0 & 0 & 0 \\ -\sin\theta_{k,1} & -j\cos\theta_{k,1} & 0 & 0 & \dots & 0 & 0 & 0 \\ 0 & 0 & -j\cos\theta_{k,2} & -\sin\theta_{k,2} & \dots & 0 & 0 & 0 \\ 0 & 0 & -\sin\theta_{k,2} & -j\cos\theta_{k,2} & \dots & 0 & 0 & 0 \\ \vdots & \vdots & \vdots & \vdots & \ddots & \vdots & \vdots & \vdots \\ 0 & 0 & 0 & 0 & \dots & -j\cos\theta_{k,N'} & -\sin\theta_{k,N'} & 0 \\ 0 & 0 & 0 & 0 & \dots & -\sin\theta_{k,N'} & -j\cos\theta_{k,N'} & 0 \\ 0 & 0 & 0 & 0 & \dots & 0 & 0 & 1 \end{pmatrix}$$

avec N' = (N-1)/2.

Le déphasage réalisé par la matrice de déphasage $\Phi_k$ consiste à ajouter au niveau de la sortie des coupleurs hybrides 17 une ligne de transmission 18 au niveau de chaque sortie. Les lignes de transmissions 18 permettent, selon leur longueur, de modifier la phase du signal entre l'entrée $X_k^{'}$ et la sortie $X_k^{''}$ selon la relation :

$$X_k^{''}(i) = X_k^{'}(i)e^{j\phi_{k,i}},$$

avec $\phi_{k,i} = -\beta\Delta l_{k,i} + 2\pi n$ où :

- $\beta$ est la constante de propagation de la ligne de transmission,
- $\Delta l_{k,i}$ sa longueur physique et ,
- n un nombre entier.

En écriture matricielle, les matrices de déphasage $\Phi_k$ s'écrivent sous la forme :

$$\phi_k = \begin{pmatrix} e^{j\varphi_{k,1}} & 0 & ... & 0 \\ 0 & e^{j\varphi_{k,2}} & ... & 0 \\ \vdots & \vdots & \ddots & \vdots \\ 0 & 0 & ... & e^{j\varphi_{k,N}} \end{pmatrix}$$

La matrice de permutation $\Pi_k$ consiste à connecter les entrées $X_k^{"}$ aux sorties $X_{k+1}$ en permutant leur ordre. L'opération est similaire à celle réalisée par l'interface de distribution $S_0$ à la différence près que le nombre d'entrées $X_k^{"}$ est ici égal au nombre de sorties $X_{k+1}$.

Dans ce cas, on peut représenter plus simplement les connexions par une permutation $p_k$ de l'ensemble {1,..., N} que l'on écrit :

$$p_k = (p_k(1), p_k(2),..., p_k(k)),$$

c'est-à-dire, que la première entrée est connectée à la sortie $p_k(1)$, la deuxième entrée est connectée à la sortie $p_k(2)$ et ainsi de suite. A cette permutation est associée une matrice de permutation $\Pi_k$ au sens mathématique, dont chaque élément est défini par :

$$\Pi_k(i, j) = \begin{cases} 1 & si \ i = p_k(j) \\ 0 & sinon \end{cases} .$$

Ainsi, par exemple, si $p_k$ = (1,3,4,2) alors on obtient l'écriture matricielle suivante :

$$\Pi_k = \begin{pmatrix} 1 & 0 & 0 & 0 \\ 0 & 0 & 1 & 0 \\ 0 & 0 & 0 & 1 \\ 0 & 1 & 0 & 0 \end{pmatrix}$$

Chaque étage peut donc être représenté par une relation matricielle globale suivante ;

$$X_{k+1} = S_k X_k = \Pi_k \Phi_k C_k X_k.$$

Parmi les éléments décrits précédemment, certains sont figés, comme les permutations $p_k$ et les connexions représentées par la matrice $S_0$ et d'autres peuvent être optimisés, ce sont les paramètres $\theta_{k,i}$ et $\phi_{k,i}$.

Le choix des permutations et des connexions représentées par la matrice $S_0$ est donc réalisé de manière à faciliter l'optimisation des paramètres $\theta_{k,i}$ et $\phi_{k,i}$.

En particulier, on remarque que si la matrice $S_0$ est mal choisie, certains coupleurs du premier étage $C_1$ peuvent avoir deux entrées connectées à la charge adaptée, et donc deviennent inutiles dans l'optimisation (n'ayant pas de signal d'entrée, il n'y aura pas de signal de sortie). Afin de répartir au mieux les entrées par rapport aux sorties, nous avons choisi avantageusement de définir la matrice $S_0$ de la manière suivante :

$$S_k(i, j) = \begin{cases} 1 & \text{si} \quad \mu(j) = i \\ 0 & \text{sinon} \end{cases},$$

$$\mu(j) = E\left(\frac{(j-1)N}{M}\right) + 1,$$ avec où $E$ est la partie entière.

Par exemple, pour $N = 16$ et $M = 8$, $N/M = 2$, on retrouve la matrice $S_0$ présentée précédemment, à savoir :

$$S_0 = \begin{pmatrix} 1 & 0 & 0 & 0 & 0 & 0 & 0 & 0 \\ 0 & 0 & 0 & 0 & 0 & 0 & 0 & 0 \\ 0 & 1 & 0 & 0 & 0 & 0 & 0 & 0 \\ 0 & 0 & 0 & 0 & 0 & 0 & 0 & 0 \\ 0 & 0 & 1 & 0 & 0 & 0 & 0 & 0 \\ 0 & 0 & 0 & 0 & 0 & 0 & 0 & 0 \\ 0 & 0 & 0 & 1 & 0 & 0 & 0 & 0 \\ 0 & 0 & 0 & 0 & 0 & 0 & 0 & 0 \\ 0 & 0 & 0 & 0 & 1 & 0 & 0 & 0 \\ 0 & 0 & 0 & 0 & 0 & 0 & 0 & 0 \\ 0 & 0 & 0 & 0 & 0 & 1 & 0 & 0 \\ 0 & 0 & 0 & 0 & 0 & 0 & 0 & 0 \\ 0 & 0 & 0 & 0 & 0 & 0 & 1 & 0 \\ 0 & 0 & 0 & 0 & 0 & 0 & 0 & 0 \\ 0 & 0 & 0 & 0 & 0 & 0 & 0 & 1 \\ 0 & 0 & 0 & 0 & 0 & 0 & 0 & 0 \end{pmatrix}$$

Le choix des permutations $p_k$ relève quant à lui d'une démarche plus heuristique. Selon le nombre $N$ d'éléments rayonnants, les permutations $p_k$ peuvent être définies de façon différente.

A titre d'exemple, pour $N=16$ et pour 3 étages, on peut choisir les permutations suivantes :

$$p_1 = p_3 = (1, 3, 2, 4, 5, 7, 6, 8, 9, 11, 10, 12, 13, 15, 14, 16),$$

et

$$p_2 = (1, 5, 2, 6, 3, 7, 4, 8, 5, 9, 13, 10, 14, 11, 15, 12, 16).$$

Une dizaine d'essais permettent généralement de trouver les meilleures permutations $p_k$ selon la valeur de $N$ et le nombre d'étages souhaités.

La matrice $L$ étant libre, tous ses coefficients complexes peuvent être optimisés. Ainsi, pour $N=16$ éléments rayonnants, $M=8$ modes et pour deux étages, le nombre de paramètres à optimiser correspond à 48 inconnues de valeur réelle : $\phi_{k,i}$ (32 inconnues, 16 par étage) et $\theta_{k,i}$ (16 inconnues, 8 par étage), auxquelles il faut ajouter 64 inconnues de valeurs complexes pour les coefficients de la matrice $L$.

L'algorithme d'optimisation utilise 3 routines imbriquées : $f_p$, $f_{nl}$, $f_{lin}$.

La routine $f_{lin}$ d'optimisation linéaire prend pour argument une matrice H et renvoie la matrice L qui minimise

l'erreur : $\varepsilon = \|P - HL)W\|$. Elle permet donc de déterminer la matrice $L$ à partir d'une implémentation donnée de la matrice H. L'optimisation est dite linéaire et on peut démontrer (par une décomposition dite QR) qu'il existe une solution unique. La routine fournit donc la matrice $L$ et l'erreur $\varepsilon$.

La routine $f_{nl}$ d'optimisation non linéaire prend pour argument une combinaison estimée de $\theta_{k,i}$ et $\phi_{k,i}$. Cette routine utilise une optimisation de type non linéaire, comme l'optimisation de Gauss-Newton. A toutes combinaisons est associée une matrice H comme décrit précédemment. Cette optimisation cherche une combinaison de $\theta_{k,i}$ et $\phi_{k,i}$ telle $f_{lin}(H)$ renvoie une erreur $\varepsilon$ minimale locale. Cette routine renvoie une combinaison optimale de $\theta_{k,i}$ et $\phi_{k,i}$, la matrice $L$ et l'erreur $\varepsilon$ minimale.

La routine $f_p$ principale ne prend pas d'argument. Elle tire au hasard une combinaison $\theta_{k,i}$ et $\phi_{k,i}$ et l'envoie dans la routine $f_{nl}$. Un nombre important de combinaisons sont choisies au hasard. Cette routine $f_p$ permet d'explorer un grand nombre de minimaux locaux. Le plus petit des minima sera choisi comme solution finale du problème.

L'ensemble du processus décrit permet donc d'obtenir une matrice de pilotage $\tilde{P}$ qui s'approche le plus de la matrice de pilotage P donnée au départ. Toutes les routines peuvent être codées dans l'environnement de calcul Matlab, ou tout autre environnement.

La réalisation du répartiteur compact requiert, pour chaque étage, des coupleurs hybrides universaux 17 (figure 3). Chacun des coupleurs est caractérisé par un paramètre unique, son angle de couplage, noté $\theta_{k,i}$ où i désigne le numéro du coupleur dans l'étage k. La valeur du couplage $C_{k,i}$ en dB est définie par :

$$C_{k,i} = -20\log_{10}\left|\sin\theta_{k,i}\right|.$$

Avantageusement, le répartiteur compact est réalisé à partir d'un même type de coupleur hybride, tel que par exemple avec un couplage de 6 dB. Le couplage à 6dB signifie que 25% de la puissance entrante (entrée 1) passe par la voie couplée (sortie 2).

Selon un autre mode de réalisation, chaque hybride universel d'angle $\theta$ pourrait être synthétisé individuellement sur la base d'un coupleur hybride de type « branch-line » ([11] « Branch-Line Couplers Using Unequal Line Lengths », IEEE Transactions on MTT, vol. 49, no. 4, 2001, Toker, C. et al.). Toutefois, ce mode de réalisation représenterait un effort et un surcoût important dans la réalisation du module du pilotage car un grand nombre de coupleurs « branch-line » différents serait nécessaire. Le procédé selon l'invention permet de réalisation un module de pilotage ne comportant qu'un seul type de coupleur « branch-line ».

De plus, l'utilisation d'un même type d'hybride universel d'une valeur de $\theta$ donnée peut permettre de générer facilement une gamme d'hybrides universaux de valeurs de $\theta$ différentes, à partir de déphasage et de permutation des entrées et sorties.

En particulier, avec un coupleur hybride « branch-line » de 6dB , qui correspond à l'hybride universel d'angle $\theta=30°$, il est possible de réaliser, à partir de déphasage et de permutation des entrées et des sorties, des hybrides universaux pour les valeurs d'angle $\theta \in \{30°,60°,120°,150°,210°,240°,300°,330°\}$. Si nous ajoutons à cette gamme d'hybrides les hybrides d'angle $\theta \in \{0°,90°,180°,270°\}$, nous obtenons un espace des solutions discrétisées pour les hybrides universaux.

Les solutions de l'algorithme d'optimisation peuvent alors être arrondies à ces valeurs discrètes. Or, il se trouve que les 4 derniers hybrides ($\theta \in \{0°,90°,180°,270°\}$) correspondent simplement à des connexions directes ou croisée avec un déphasage :

- $\theta = 0°$ correspond à une connexion directe (entrée $e_1$ sur sortie $s_1$ et entrée $e_2$ sur sortie $s_2$) avec un déphasage de -90°,
- $\theta = 90°$ correspond à une connexion croisée (entrée $e_1$ sur sortie $s_2$ et entrée $e_2$ sur sortie $s_1$) avec un déphasage de 180°,
- $\theta = 180°$ correspond à une connexion directe avec un déphasage de 90°,
- $\theta = 180°$ correspond à une connexion croisée sans déphasage (ou 360°).

Cette approche d'arrondi à des valeurs discrètes pour les hybrides universaux simplifie grandement la réalisation du répartiteur compact caractérisé par la matrice H .

Une telle réalisation avec un même type de coupleur résulte donc de la réalisation d'une matrice de pilotage compact de paramètre $\theta$, de discrétisation de paramètre $\theta$ et de l'approche d'arrondi à des valeurs discrètes de $\theta$.

Il est également possible de discrétiser l'espace des solutions avec un pas de 15°. Cela nécessitera en revanche deux autres coupleurs « branch-line », l'un à 3dB et l'autre à 11,7dB. En pratique, une discrétisation à 30° suffit.

Avec l'arrondi des angles des hybrides universaux à des valeurs discrètes espacées de 30° (ou 15°), il est nécessaire de réaliser une seconde optimisation sur les matrices de déphasage $\Phi_k$. L'optimisation utilise les mêmes routines $f_p$, $f_{nl}$, $f_{lin}$ mais les angles des coupleurs $\theta_{k,i}$ sont alors imposés (valeurs arrondies).

La figure 5 illustre un exemple de réalisation d'un répartiteur compact associé à la matrice H pour le pilotage d'une antenne comportant 16 éléments rayonnants à partir de 8 éléments de pilotage et à partir de la décomposition d'une matrice de Butler.

La matrice de Butler pour une antenne à 16 éléments rayonnants nécessite usuellement 4 étages de coupleurs. Grâce au procédé selon l'invention, nous obtenons pour 8 modes un résultat approché, suffisamment précis pour l'application IRM, de la matrice de Butler avec seulement 2 étages 10 de coupleurs.

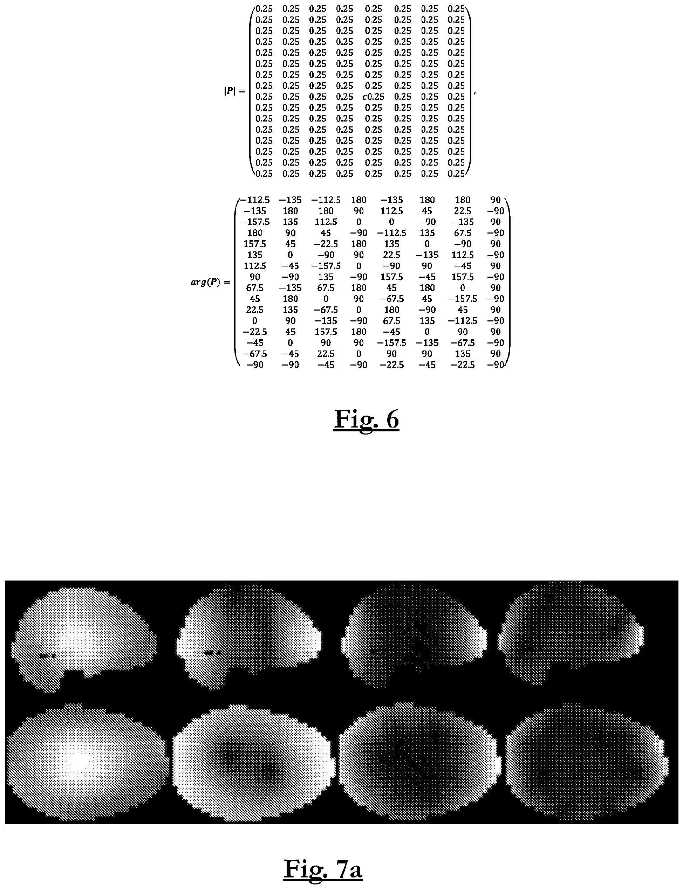

Ainsi, pour les 7 modes polarisés circulairement dans le sens de rotation des spins, pour l'application IRM, et pour un mode mixte, la matrice de pilotage *P*, de valeurs complexes, est définie par les matrices des amplitudes et des phases illustrées à la figure 6.

La valeur 0.25 correspond à $1/\sqrt{16}$ de la puissance d'entrée car chaque élément rayonnant est alimenté avec la même puissance. Sur les 8 modes, seuls les 4 premiers sont prépondérants dans l'homogénéisation de l'excitation des spins.

Pour l'optimisation de ce mode de réalisation, il a été choisi la matrice W, les coefficients suivants :

$$W(i,i) = \frac{1}{i+1}$$

Ceci permet d'obtenir une erreur d'approximation plus faible pour les premiers modes au détriment des derniers. La première optimisation (sans arrondi) donne un résultat avec les erreurs suivantes :

$$\left|P - \tilde{P}\right| = \begin{pmatrix} 0,04 & 0,04 & 0,07 & 0,05 & 0,04 & 0,13 & 0,22 & 0,26 \\ 0,03 & 0,02 & 0,04 & 0,04 & 0,04 & 0,08 & 0,14 & 0,20 \\ 0,02 & 0,03 & 0,05 & 0,04 & 0,02 & 0,07 & 0,14 & 0,20 \\ 0,04 & 0,04 & 0,07 & 0,05 & 0,02 & 0,11 & 0,20 & 0,24 \\ 0,04 & 0,04 & 0,07 & 0,05 & 0,04 & 0,13 & 0,22 & 0,26 \\ 0,03 & 0,02 & 0,04 & 0,04 & 0,04 & 0,08 & 0,14 & 0,20 \\ 0,02 & 0,03 & 0,05 & 0,04 & 0,02 & 0,07 & 0,14 & 0,20 \\ 0,04 & 0,04 & 0,07 & 0,05 & 0,02 & 0,11 & 0,20 & 0,24 \\ 0,04 & 0,04 & 0,07 & 0,04 & 0,04 & 0,13 & 0,21 & 0,26 \\ 0,02 & 0,02 & 0,04 & 0,03 & 0,03 & 0,08 & 0,15 & 0,21 \\ 0,03 & 0,02 & 0,05 & 0,04 & 0,02 & 0,07 & 0,14 & 0,21 \\ 0,04 & 0,04 & 0,07 & 0,04 & 0,03 & 0,12 & 0,20 & 0,25 \\ 0,04 & 0,04 & 0,07 & 0,05 & 0,02 & 0,11 & 0,20 & 0,24 \\ 0,03 & 0,03 & 0,05 & 0,04 & 0,02 & 0,07 & 0,14 & 0,20 \\ 0,02 & 0,02 & 0,04 & 0,03 & 0,04 & 0,08 & 0,14 & 0,20 \\ 0,04 & 0,04 & 0,07 & 0,05 & 0,04 & 0,13 & 0,22 & 0,26 \end{pmatrix}$$

On voit par ce résultat qu'effectivement, l'erreur est plus grande pour les derniers modes (dernières colonnes de la matrice erreur), pour lesquels, les valeurs de *W* étaient plus faibles.

Après les arrondis vers un espace des solutions discrétisée à 30°, la seconde optimisation produit une solution caractérisée par la matrice erreur suivante :

$$|P - \tilde{P}| = \begin{pmatrix} 0,06 & 0,01 & 0,02 & 0,05 & 0,04 & 0,11 & 0,22 & 0,22 \\ 0,07 & 0,04 & 0,04 & 0,07 & 0,04 & 0,11 & 0,22 & 0,27 \\ 0,03 & 0,03 & 0,05 & 0,05 & 0,02 & 0,08 & 0,22 & 0,26 \\ 0,03 & 0,01 & 0,03 & 0,03 & 0,02 & 0,07 & 0,16 & 0,17 \\ 0,06 & 0,01 & 0,02 & 0,05 & 0,04 & 0,11 & 0,22 & 0,22 \\ 0,07 & 0,04 & 0,04 & 0,07 & 0,04 & 0,11 & 0,22 & 0,27 \\ 0,03 & 0,03 & 0,05 & 0,05 & 0,02 & 0,08 & 0,22 & 0,26 \\ 0,03 & 0,01 & 0,03 & 0,03 & 0,02 & 0,07 & 0,16 & 0,17 \\ 0,06 & 0,01 & 0,02 & 0,05 & 0,04 & 0,11 & 0,22 & 0,22 \\ 0,07 & 0,04 & 0,04 & 0,07 & 0,03 & 0,11 & 0,22 & 0,27 \\ 0,03 & 0,03 & 0,05 & 0,05 & 0,02 & 0,08 & 0,22 & 0,26 \\ 0,03 & 0,01 & 0,03 & 0,03 & 0,03 & 0,07 & 0,16 & 0,17 \\ 0,03 & 0,01 & 0,03 & 0,03 & 0,02 & 0,07 & 0,16 & 0,17 \\ 0,03 & 0,03 & 0,05 & 0,05 & 0,02 & 0,08 & 0,22 & 0,26 \\ 0,07 & 0,04 & 0,04 & 0,07 & 0,04 & 0,11 & 0,22 & 0,27 \\ 0,06 & 0,01 & 0,02 & 0,05 & 0,04 & 0,11 & 0,22 & 0,22 \end{pmatrix}$$

On constate que la réduction de l'implémentation à un seul type de coupleur « branch-line » de 6 dB n'augmente pas significativement les erreurs de la synthèse, mais simplifie largement la réalisation matérielle du répartiteur compact illustré à la figure 5.

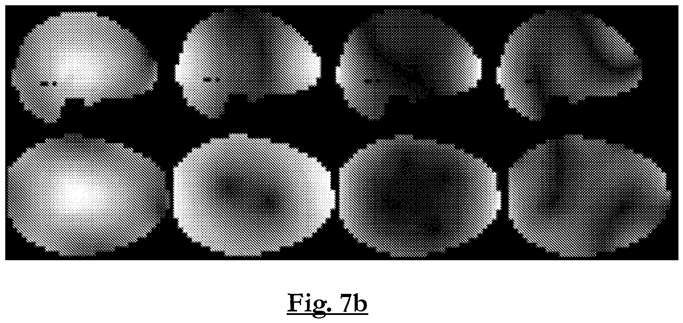

Afin de donner une idée de la précision de la synthèse des modes de pilotage sur les cartes de champs dits |B1+| utilisés pour l'excitation des spins en IRM obtenu par le procédé selon l'invention en comparaison à un procédé utilisant uniquement la matrice de Butler pour l'implémentation du module de pilotage, les figures 7a et 7b illustrent les cartes de champs obtenues pour les modes 1, 3, 5 et 7 sur la coupe sagittale et axiale d'un modèle de cerveau. La figure 7a illustre les cartes de champs obtenues avec la matrice de Butler originelle (i.e. 4 étages) et la figure 7b illustre les cartes de champs obtenues au moyen du module de pilotage selon l'invention comportant deux étages.

## Revendications

1. Procédé de réalisation d'un module de pilotage simplifié pour le pilotage d'une antenne haute fréquence pour appareil d'imagerie par résonance magnétique comportant une pluralité *M* d'éléments de pilotage et une pluralité *N* d'éléments rayonnants, ladite pluralité *N* d'éléments rayonnants étant supérieure à ladite pluralité *M* d'éléments de pilotage, ladite antenne étant associée à une matrice de pilotage *P* de dimension *NxM,* dont chaque colonne représente un mode de rayonnement de l'antenne et permettant de transformer une variable d'entrée $V_m$ associée à chacun des *M* éléments de pilotage, en une variable de sortie $V_a$ associée à chacun des *N* d'éléments rayonnants de ladite antenne, ledit procédé comportant :

- une étape de détermination d'un nombre d'étages *K* permettant de distribuer *N* signaux d'entrée ordonnés sur *N* signaux de sortie ordonnés différents avec un couplage, un déphasage et une permutation propre à chaque signal, chaque étage correspondant à une composition physique de trois éléments formés par des coupleurs hybrides, des lignes de déphasage et des permutations de lignes, le nombre d'étages *K* étant inférieur au nombre d'étages nécessaires à l'implémentation de la matrice de pilotage *P* de l'antenne par une matrice de Butler ou une matrice obtenue par une décomposition en valeurs singulières ;
- une étape d'optimisation d'une matrice de pilotage *P̃* définie par un produit de deux matrices *HL* ;

- la première matrice *L,* de dimension *M×M*, étant apte à transformer en amplitude et en phase une pluralité

de $M$ signaux $V_m$ émis par ladite pluralité $M$ d'éléments de pilotage en $M$ signaux $V_1$, la matrice $L$ étant différente de la matrice identité ;
- la deuxième matrice $H$ de dimension $N \times M$ recevant en entrées lesdits $M$ signaux $V_1$, ladite matrice $H$ étant définie par une décomposition d'une pluralité $K+1$ de matrice $S$ selon la relation :

$$H = S_K S_{K-1} \dots S_1 S_0$$

Avec :

$S_0$ matrice de dimension $N \times M$ qui assure une connexion entre les $M$ entrées et les $N$ sorties sans modifier les signaux;
$S_k$ matrice de dimension $M \times M$ correspondant à chaque étage, avec $k = \{1,...,K\}$;
l'étape d'optimisation étant réalisée au moyen d'une routine d'optimisation cherchant à minimiser l'erreur : $\varepsilon = \|(\tilde{P} - P)W\|$ où : $\| \|$ désigne la norme euclidienne ;
$W$ désigne une matrice diagonale de dimension $M \times M$ dont les coefficients définissent le poids de chaque mode dans le calcul de l'erreur ;

- une étape de fabrication de ladite matrice $H$ avec un nombre d'étages $K$, ladite matrice $H$ étant implémentée par des moyens de couplage formés par des coupleurs hybrides, des moyens de déphasage et des moyens de permutation ;
- une étape de mise en oeuvre de ladite matrice $L$ par des moyens logiciels à partir de l'implémentation de ladite matrice $H$ déterminée lors de l'étape précédente.

2. Procédé de réalisation d'un module de pilotage d'une antenne haute fréquence pour appareil d'imagerie par résonance magnétique selon la revendication 1 **caractérisé en ce que** ladite matrice $H$ implémentée comporte un nombre d'étages $K$ inférieur à :

$$E_{\text{sup}}(\ln(N)/\ln(2)) \, ,$$

avec :

- $E_{sup}$ correspond à la partie entière supérieure
- « *ln* » correspondant au logarithme népérien.

3. Procédé de réalisation d'un module de pilotage d'une antenne haute fréquence pour appareil d'imagerie par résonance magnétique selon l'une des revendications 1 à 2 **caractérisé en ce que** chacune desdites matrices $S_k$ avec $k = \{1,...,K\}$ est formée par le produit matriciel d'une matrice de couplage $C_k$, d'une matrice de déphasage $\Phi_k$ et d'une matrice de permutation $\Pi_k$, de sorte qu'un signal $X_{k+1}$ en sortie de l'étage $k$ du module de pilotage est fonction de la relation :

$$X_{k+1} = S_k X_k = \Pi_k \Phi_k C_k X_k ,$$

Avec :

- $X_k$ représentant le signal d'entrée arrivant au niveau dudit étage $k$,
- $C_k$ étant différente d'une matrice identité.

4. Procédé de réalisation d'un module de pilotage d'une antenne haute fréquence pour appareil d'imagerie par résonance magnétique selon la revendication 3 **caractérisé en ce que** ladite matrice de couplage $C_k$ est implémentée par lesdits moyens de couplage (17), ladite matrice de déphasage $\Phi_k$ est implémentée par lesdits moyens de déphasage (18), et ladite matrice de permutations $\Pi_k$ est implémentée par lesdits moyens de permutations (19).

5. Procédé de réalisation d'un module de pilotage d'une antenne haute fréquence pour appareil d'imagerie par résonance magnétique selon l'une des revendications 1 à 4 **caractérisé en ce que** lesdits moyens de couplage (17) sont des coupleurs hybrides universaux à 6dB.

**6.** Module de pilotage (10) obtenu par le procédé de réalisation selon l'une des revendications 1 à 5 pour le pilotage d'un antenne haute fréquence pour appareil d'imagerie par résonance magnétique comportant une pluralité *M* d'éléments de pilotage et une pluralité *N* d'éléments rayonnants, ladite pluralité *N* d'éléments rayonnants étant supérieure à ladite pluralité *M* d'éléments de pilotage, ladite antenne étant associée à une matrice de pilotage *P* de dimension *N×M*, permettant de transformer une variable d'entrée $V_m$ associée à chacun des *M* éléments de pilotage, en une variable de sortie $V_a$ associée à chacun des *N* d'éléments rayonnants de ladite antenne, ledit module étant **caractérisé en ce qu'**il comporte un agencement de moyens de couplage hybrides (17), de moyens de déphasage (18) et de moyens de permutations (19) et de moyens logiciels de sorte que lesdits *N* signaux $V_a$ de sortie dudit module de pilotage (10), sont fonction de la relation :

$$V_a = HLV_m$$

avec :

- $V_m$ représentant les *M* signaux d'entrée dudit module de pilotage (10) ;
- *H* matrice de dimension *N×M* apte à être implémentée par lesdits moyens de couplage (17), lesdits moyens de déphasage (18), lesdits moyens de permutations (19) ;
- *L* matrice de dimension *M×M* apte à être mise en œuvre par lesdits moyens logiciels.

## Patentansprüche

**1.** Realisierungsverfahren eines vereinfachten Steuermoduls zum Steuern einer Hochfrequenz-Antenne für ein Bildgebungsgerät per Magnetresonanz, umfassend eine Vielzahl von *M* Steuerelementen und eine Vielzahl von *N* strahlenden Elementen, wobei die genannte Vielzahl von *N* strahlenden Elementen größer ist als die genannte Vielzahl von *M* Steuerelementen, wobei die genannte Antenne einer Steuermatrix *P* mit den Abmessungen *NxM* zugeordnet ist, von denen jede Spalte einen Strahlungsmodus der Antenne darstellt und das Umwandeln einer Eingangsvariablen $V_m$, die jedem der *M* Steuerelemente zugeordnet ist, in eine Ausgangsvariable $V_a$, die jedem der strahlenden Elemente *N* der genannten Antenne zugeordnet ist, zulässt, wobei das genannte Verfahren umfasst:

- einen Bestimmungsschritt einer Anzahl von Stufen *K,* die das Verteilen *N* von geordneten Eingangssignalen über *N* geordnete unterschiedliche Ausgangssignale mit einer Kopplung, einer Phasenverschiebung und einem jedem Signal eigenen Auskreuzen, wobei jede Stufe einer physischen Zusammensetzung von drei Elementen entspricht, die von hybriden Kopplern, Phasenverschiebungsleitungen und Auskreuzleitungen geformt sind; wobei die Anzahl von Stufen *K* kleiner ist als die Anzahl von notwendigen Stufen zum Implementieren der Steuermatrix *P* der Antenne durch eine Butler-Matrix oder eine Matrix, die von einer Aufgliederung in einzelne Werte erhalten ist,
- einen Optimierungsschritt einer Steuermatrix $\tilde{P}$, die von einem Produkt aus zwei Matrizen *HL* definiert ist;

  - wobei die erste Matrix *L* mit den Abmessungen *MxM* geeignet ist, eine Vielzahl von *M* Signalen $V_m$, die von der genannten Vielzahl von *M* Steuerelementen ausgegeben ist, in der Amplitude und der Phase in *M* Signal $V_P$ umzuwandeln, wobei die Matrix *L* von der Identitätsmatrix unterschiedlich ist;
  - wobei die zweite Matrix *H* mit den Abmessungen *NxM* in den Eingängen die genannten *M* Signale $V_t$ empfängt, wobei die genannte Matrix *H* durch eine Aufgliederung einer Vielzahl von *K*+1 Matrizen S gemäß der Beziehung definiert ist:

$$H = S_K S_{K-1} \ldots S_1 S_0$$

wobei: $S_0$ die Abmessungsmatrix *NxM* ist, die einen Anschluss zwischen den *M* Eingängen und den *N* Ausgängen gewährleistet, ohne die Signale abzuändern; $S_k$ die Abmessungsmatrix *MxM* ist, die jedem Schritt entspricht, wobei *k* = *{1, ..., K}* entspricht; wobei der Optimierungsschritt mittels einer Optimierungsroutine durchgeführt ist, die das Minimieren des Fehlers versucht: $\varepsilon = \|(\tilde{P}\text{-}P)W\|$ wobei: $\| \|$ die euklidische Norm bezeichnet; *W* eine diagonale Matrix mit den Abmessungen *MxM* bezeichnet, deren Koeffizienten das Gewicht jedes Modus bei der Berechnung des Fehlers definieren;

- ein Herstellungsschritt der genannten Matrix $H$ mit einer Anzahl von Stufen $K$, wobei die genannte Matrix $H$ mittels Kopplungen implementiert ist, die durch hybride Koppler, PhasenverschiebungsMittel und Auskreuzmitteln geformt sind;

- einen Umsetzungsschritt der genannten Matrix $L$ durch Softwaremittel ausgehend von der Implementierung der genannten Matrix $H$, die bei dem voranstehenden Schritt bestimmt ist.

2. Realisierungsverfahren eines Steuermoduls einer Hochfrequenz-Antenne für ein Bildgebungsgerät per Magnetresonanz gemäß Anspruch 1, **dadurch gekennzeichnet, dass** die genannte implementierte Matrix $H$ eine Anzahl von Stufen $K$ umfasst, die kleiner ist als:

$$E_{sup}(1n(N)/1n(2)),$$

wobei

- $E_{sup}$ dem oberen ganzen Teil entspricht
- *"ln"* dem natürlichen Logarithmus entspricht.

3. Realisierungsverfahren eines Steuermoduls einer Hochfrequenz-Antenne für ein Bildgebungsgerät per Magnetresonanz gemäß einem der Ansprüche 1 bis 2, **dadurch gekennzeichnet, dass** jede der genannten Matrizen $S_k$ mit $k = \{1, ..., K\}$ durch das Matrixprodukt einer Kopplungsmatrix $C_k$, einer Phasenverschiebungsmatrix $\Phi_k$ und einer Auskreuzmatrix $\Pi_k$ derart gebildet ist, dass ein Signal $X_{k+1}$ am Ausgang der Stufe $k$ des Steuermoduls eine Funktion der Beziehung ist:.

$$X_{k+1} = S_k X_k = \Pi_k \Phi_k C_k X_k,$$

wobei:

- $X_k$ das Eingangssignal darstellt, das an der genannten Stufe $k$ eintrifft,
- $C_k$ von einer Identitätsmatrix unterschiedlich ist.

4. Realisierungsverfahren eines Steuermoduls einer Hochfrequenz-Antenne für ein Bildgebungsgerät per Magnetresonanz gemäß Anspruch 3, **dadurch gekennzeichnet, dass** die genannte Kopplungsmatrix $C_k$ durch die genannten Kopplungsmittel (17) implementiert ist, wobei die genannte Phasenverschiebungsmatrix $\Phi_k$ durch die genannten Phasenverschiebungsmittel (18) implementiert ist und die genannte Auskreuzmatrix $\Pi_k$ durch die genannten Auskreuzmittel (19) implementiert ist.

5. Realisierungsverfahren eines Steuermoduls einer Hochfrequenz-Antenne für ein Bildgebungsgerät per Magnetresonanz gemäß einem der Ansprüche 1 bis 4, **dadurch gekennzeichnet, dass** die genannten Kopplungsmittel (17) universelle, hybride Koppler zu 6 dB sind.

6. Steuermodul (10), das durch das Realisierungsverfahren gemäß einem der Ansprüche 1 bis 5 zum Steuern einer Hochfrequenz-Antenne für ein Bildgebungsgerät per Magnetresonanz erhalten ist, umfassend eine Vielzahl von $M$ Steuerelementen und eine Vielzahl von $N$ strahlenden Elementen, wobei die genannte Vielzahl von $N$ strahlenden Elementen höher ist als die genannte Vielzahl von $M$ Steuerelementen, wobei die genannte Antenne einer Steuermatrix $P$ mit den Abmessungen $NxM$ zugeordnet ist, die das Umwandeln einer Eingangsvariablen $V_m$, die jedem der $M$ Steuerelemente zugeordnet ist, in eine Ausgangsvariable $V_a$ zulässt, die jedem der $N$ strahlenden Elemente der genannten Antenne zugeordnet ist, wobei das genannte Modul **dadurch gekennzeichnet ist, dass** es eine Anordnung von hybriden Kopplungsmitteln (17), von Phasenverschiebungsmitteln (18) und Auskreuzmitteln (19) und Softwaremitteln derart umfasst, dass die genannten $N$ Ausgangssignale $V_a$ des genannten Steuermoduls (10) eine Funktion der Beziehung sind:

$$V_a = HLV_m,$$

wobei:

- $V_m$ die $M$ Eingangssignale des genannten Steuermoduls (10) darstellt;
- $H$ die Matrix mit den Abmessungen $NxM$ ist, die geeignet ist, durch die genannten Kopplungsmittel (17), die genannten Phasenverschiebungsmittel (18), die genannten Auskreuzmittel (19), implementiert zu sein;
- $L$ die Matrix mit den Abmessungen $M x M$ ist, die geeignet ist, von den genannten Software-Mitteln umgesetzt zu sein.

**Claims**

1. Method of producing a simplified control module for controlling a high-frequency antenna for a magnetic resonance imaging device comprising a plurality of $M$ control elements and a plurality of $N$ radiating elements, said plurality $N$ of radiating elements being greater than said plurality $M$ of control elements, said antenna being associated with a control matrix $P$ of dimensions $NxM$, of which each column represents a radiation mode of the antenna and making it possible to transform an input variable $V_m$ associated with each one of the $M$ control elements, into an output variable $V_a$ associated with each one of the $N$ radiating elements of said antenna, said method comprising:

   - a step of determining a number of stages $K$ making it possible to distribute $N$ ordered input signals over $N$ different ordered output signals with a coupling, a phase displacement and a permutation specific to each signal, with each stage corresponding to a physical composition of three elements formed by hybrid couplers, phase displacement lines and line permutations, the number of stages $K$ being less than the number of stages required for the implementation of the control matrix $P$ of the antenna by a Butler matrix or a matrix obtained by a dividing into singular values;
   - a step of optimising a control matrix $\tilde{P}$ defined by a product of two matrices $HL$;
   - the first matrix $L$, of dimensions $MxM$, being able to transform in amplitude and in phase a plurality of $M$ signals $V_m$ emitted by said plurality $M$ of control elements into $M$ signals $V_l$, the matrix $L$ being different from the identity matrix;
   - the second matrix $H$ of dimensions $NxM$ receiving as input said M signals $V_l$, said matrix $H$ being defined by a dividing of a plurality of $K+1$ of matrix S according to the relationship:

$$H = S_K S_{K-1} \ldots S_1 S_0$$

   With:

   $S_0$ matrix of dimensions $NxM$ which provides a connection between the $M$ inputs and the $N$ outputs without modifying the signals;
   $S_k$ matrix of dimensions $MxM$ corresponding to each stage, with k = $\{1, \ldots ,K\}$;
   the step of optimising being carried out by means of an optimisation routine that seeks to minimise the error: $\varepsilon = \|(\tilde{P} - P)W\|$ where: $\| \|$ designates the Euclidean norm;
   $W$ designates a diagonal matrix of dimensions $MxM$ of which the coefficients define the weight of each mode in the calculation of the error;

   - a step of manufacturing said matrix $H$ with a number of stages $K$, said matrix $H$ being implemented by coupling means formed by hybrid couplers, means of phase displacement and means of permutation;
   - a step of implementing said matrix $L$ by software means using the implementation of said matrix $H$ determined during the preceding step.

2. Method of producing a control module for a high-frequency antenna for a magnetic resonance imaging device according to claim 1 **characterised in that** said matrix $H$ implemented includes a number of stages K less than:

$$E_{sup}(\ln(N)/\ln(2)),$$

   with:

   - $E_{sup}$ corresponds to the higher integer portion
   - *"ln"* corresponding to the Naperian logarithm.

3. Method of producing a control module for a high-frequency antenna for a magnetic resonance imaging device according to one of claims 1 to 2 **characterised in that** each one of said matrices $S_k$ with $k = \{1, ... ,K\}$ is formed by the matrix multiplication of a coupling matrix $C_k$, of a phase displacement matrix $\Phi_k$ and of a permutation matrix $\Pi_k$, in such a way that a signal $X_{k+1}$ at the output of the stage $k$ of the control module is according to the relationship:

$$X_{k+1} = S_k X_k = \Pi_k \Phi_k C_k X_k,$$

With:

- $X_k$ representing the input signal arriving on said stage $k$,
- $C_k$ being different from an identity matrix.

4. Method of producing a control module for a high-frequency antenna for a magnetic resonance imaging device according to claim 3 **characterised in that** said coupling matrix $C_k$ is implemented by said coupling means (17), said phase displacement matrix $\Phi_k$ is implemented by said phase displacement means (18), and said permutations matrix $\Pi_k$, is implemented by said permutations means (19).

5. Method of producing a control module for a high-frequency antenna for a magnetic resonance imaging device according to one of claims 1 to 4 **characterised in that** said coupling means (17) are universal hybrid couplers at 6dB.

6. Module for controlling (10) obtained by the method for producing according to one of claims 1 to 5 for controlling a high-frequency antenna for a magnetic resonance imaging device comprising a plurality of $M$ control elements and a plurality of $N$ radiating elements, said plurality $N$ of radiating elements being greater than said plurality $M$ of control elements, said antenna being associated with a control matrix $P$ of dimensions $NxM$, making it possible to transform an input variable $V_m$ associated with each one of the $M$ control elements, into an output variable $V_a$ associated with each one of the $N$ radiating elements of said antenna, said module being **characterised in that** it includes an arrangement of the hybrid coupling means (17), phase displacement means (18) and permutations means (19) and software means in such a way that said $N$ output signals $V_a$ of said control module (10), are according to the relationship:

$$V_a = HLV_m$$

with:

- $V_m$ representing the $M$ input signals of said control module (10);
- $H$ matrix of dimensions $NxM$ able to be implemented by said coupling means (17), said phase displacement means (18), said permutations means (19);
- $L$ matrix of dimensions $MxM$ able to be implemented by said software means.

Fig. 1

Fig. 2

Fig. 3

| (°) | Couplage (dB) |
|-----|---------------|
| 0 | ∞ |
| 15 | 11.7 |
| 30 | 6.0 |
| 45 | 3.0 |
| 60 | 1.25 |
| 75 | 0.30 |
| 90 | 0 |

**Fig. 4**

**Fig. 5**

$$|P| = \begin{pmatrix} 0.25 & 0.25 & 0.25 & 0.25 & 0.25 & 0.25 & 0.25 & 0.25 \\ 0.25 & 0.25 & 0.25 & 0.25 & 0.25 & 0.25 & 0.25 & 0.25 \\ 0.25 & 0.25 & 0.25 & 0.25 & 0.25 & 0.25 & 0.25 & 0.25 \\ 0.25 & 0.25 & 0.25 & 0.25 & 0.25 & 0.25 & 0.25 & 0.25 \\ 0.25 & 0.25 & 0.25 & 0.25 & 0.25 & 0.25 & 0.25 & 0.25 \\ 0.25 & 0.25 & 0.25 & 0.25 & 0.25 & 0.25 & 0.25 & 0.25 \\ 0.25 & 0.25 & 0.25 & 0.25 & 0.25 & 0.25 & 0.25 & 0.25 \\ 0.25 & 0.25 & 0.25 & 0.25 & 0.25 & 0.25 & 0.25 & 0.25 \\ 0.25 & 0.25 & 0.25 & 0.25 & c0.25 & 0.25 & 0.25 & 0.25 \\ 0.25 & 0.25 & 0.25 & 0.25 & 0.25 & 0.25 & 0.25 & 0.25 \\ 0.25 & 0.25 & 0.25 & 0.25 & 0.25 & 0.25 & 0.25 & 0.25 \\ 0.25 & 0.25 & 0.25 & 0.25 & 0.25 & 0.25 & 0.25 & 0.25 \\ 0.25 & 0.25 & 0.25 & 0.25 & 0.25 & 0.25 & 0.25 & 0.25 \\ 0.25 & 0.25 & 0.25 & 0.25 & 0.25 & 0.25 & 0.25 & 0.25 \\ 0.25 & 0.25 & 0.25 & 0.25 & 0.25 & 0.25 & 0.25 & 0.25 \\ 0.25 & 0.25 & 0.25 & 0.25 & 0.25 & 0.25 & 0.25 & 0.25 \end{pmatrix},$$

$$arg(P) = \begin{pmatrix} -112.5 & -135 & -112.5 & 180 & -135 & 180 & 180 & 90 \\ -135 & 180 & 180 & 90 & 112.5 & 45 & 22.5 & -90 \\ -157.5 & 135 & 112.5 & 0 & 0 & -90 & -135 & 90 \\ 180 & 90 & 45 & -90 & -112.5 & 135 & 67.5 & -90 \\ 157.5 & 45 & -22.5 & 180 & 135 & 0 & -90 & 90 \\ 135 & 0 & -90 & 90 & 22.5 & -135 & 112.5 & -90 \\ 112.5 & -45 & -157.5 & 0 & -90 & 90 & -45 & 90 \\ 90 & -90 & 135 & -90 & 157.5 & -45 & 157.5 & -90 \\ 67.5 & -135 & 67.5 & 180 & 45 & 180 & 0 & 90 \\ 45 & 180 & 0 & 90 & -67.5 & 45 & -157.5 & -90 \\ 22.5 & 135 & -67.5 & 0 & 180 & -90 & 45 & 90 \\ 0 & 90 & -135 & -90 & 67.5 & 135 & -112.5 & -90 \\ -22.5 & 45 & 157.5 & 180 & -45 & 0 & 90 & 90 \\ -45 & 0 & 90 & 90 & -157.5 & -135 & -67.5 & -90 \\ -67.5 & -45 & 22.5 & 0 & 90 & 90 & 135 & 90 \\ -90 & -90 & -45 & -90 & -22.5 & -45 & -22.5 & -90 \end{pmatrix}$$

## Fig. 6

## Fig. 7a

**Fig. 7b**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4746866 A
- US 4751464 A
- US 5557247 A
- FR 100072907

**Littérature non-brevet citée dans la description**

- **KAWIN SETSOMPOP.** *Slice-Selective RF pulses for in vivo B1 inhomogeneity mitigation at 7 Tesla using parallel RF excitation with a 16-Element coil,* 2008
- **ALAGAPPAN V.** *Degenerate mode bandpass birdcage coil for accelerated parallel excitation,* 2007
- branch-line. **POZAR, D.** Microwave Engineering. Wiley, 1998
- **TOKER, C.** Branch-Line Couplers Using Unequal Line Lengths. *IEEE Transactions on MTT,* 2001, vol. 49 (4